# EUROPÄISCHE PATENTSCHRIFT

(11) **EP 1 929 848 B1**
(45) Veröffentlichungstag und Bekanntmachung des Hinweises auf die Patenterteilung: **29.04.2009**
(21) Anmeldenummer: 05802688.1
(22) Anmeldetag: 30.09.2005
(51) Int. Cl.: H05K 3/36

(54) **VERBINDUNG VON ZWEI LEITERPLATTEN ODER FLACHBAUGRUPPEN MITTELS MECHANISCHER VERRIEGELUNG**
CONNECTION OF TWO SEMI-CONDUCTOR PLATES OR FLAT COMPONENTS BY MEANS OF A MECHANICAL LOCK
CONNEXION DE DEUX CARTES DE CIRCUITS IMPRIMES OU DE MODULES PLATS AU MOYEN D'UN SYSTEME DE VERROUILLAGE MECANIQUE

(43) Veröffentlichungstag der Anmeldung: 11.06.2008
(73) Patentinhaber: SIEMENS AKTIENGESELLSCHAFT, 80333 München (DE)
(72) Erfinder: DOTZLER, Christian, 92271 Freihung (DE); GEITNER, Manuel, 92289 Ursensollen (DE); PFITZNER, Klaus, 92224 Amberg (DE); SCHATZ, Wolfgang, 92224 Amberg (DE)
(86) Internationale Anmeldenummer: PCT/DE2005/001758
(87) Internationale Veröffentlichungsnummer: WO 2007/036181

(56) Entgegenhaltungen:
- WO-A-96/08415
- DE-U- 7 316 984
- US-A- 4 513 064

## Beschreibung

Die Erfindung betrifft eine Leiterplatte mit mindestens einem Verbindungshaken zur Herstellung einer mechanischen Verbindung mit einer zweiten Leiterplatte. Die Erfindung betrifft ferner eine Leiterplatte mit mindestens einer Verbindungsausnehmung zur Herstellung einer mechanischen Verbindung mit einer zweiten Leiterplatte.

Derartige Leiterplatten kommen in allen Bereichen zum Einsatz, in denen eine formschlüssige Verbindung von zwei Leiterplatten bzw. Flachbaugruppen, die zueinander in einem Winkel im Bereich zwischen 0 Grad und 180 Grad, bevorzugt aber nahezu senkrecht zueinander, stehen, erstellt werden soll, die einer erhöhten mechanischen Belastung ausgesetzt ist, wie beispielsweise bei Schwing- oder Schockbeanspruchung insbesondere bei einem Einsatz auf dem Gebiet der Robotik. Üblicherweise sind die mechanisch verbundenen Leiterplatten zur Herstellung einer leitenden Verbindung mit Kontaktstellen versehen, die beispielsweise durch Verlöten haltbar kontaktiert werden können. Ferner können solche Leiterplatten in der Baugruppen-Vormontage verwendet werden, ohne dass es einen Einfluss bzw. eine Belastung auf bzw. für die elektrische Verbindung, d.h. die Lötstellen oder andere Formen der Kontaktierung, gibt. Als weiteres Anwendungsgebiet ist z.B. die Bestückung von Hauptplatinen mit Spezialmodulen denkbar, da diese aus Platzgründen meist senkrecht auf die Hauptplatine montiert werden.

Aus DE 73 16 984 U ist eine Anordnung zur Befestigung einer Trägerplatte mit einem Wandteil bekannt, wobei das Wandteil mehrere nach unten ragende hakenförmige Fortsätze aufweist. Dadurch, dass die Fortsätze durch Schlitze der Trägerplatte hindurchgegriffen werden, kann das Wandteil auf der Trägerplatte befestigt werden.

Aus US 4 513 064 A ist auch eine Platte bekannt, welche eine Mehrzahl von Verbindungshacken, Keilen bzw. Verbindungsausnehmungen aufweist. Solche Platten sind durch Einstecken der Verbindungshacken oder Keile einer der Platten in die Verbindungsausnehmungen einer anderen der Platten miteinander mechanisch verbindbar.

Aus US 5 484 965 ist eine Leiterplatte bekannt, die zur Montage einer zweiten Leiterplatte eine Ausnehmung aufweist, in die die zweite Leiterplatte passend einsteckbar und verlötbar ist, sodass für die mechanische Verbindung beider Leiterplatten kein zusätzliches Verbindungssystem oder andere Hardware vonnöten ist. Weitere bekannte Ausführungsformen beinhalten das Durchstecken eines am Rande einer Leiterplatte angebrachten länglichen Zapfens durch eine dafür vorgesehene Ausnehmung in der zweiten Leiterplatte, stumpfes Auflöten oder Stecken in eine gefräste Nut und anschließendes Verlöten, Verbinden mittels flexibler Leiterplatten, Verbinden mittels eines Steckers, Stifts oder einer Flachbaugruppe und einer Buchse, Verbinden von tiefengefrästen Leiterplatten und Verbinden durch SMD-lötbare (SMD: Surface Mountable Device) flexible Kontakte oder mittels Fix-Jumpern zum Durchstecken oder Einstecken in Buchsen. Keine dieser bekannten Ausführungen ist jedoch gut dazu geeignet, erhöhten mechanischen Belastungen standzuhalten.

Der Erfindung liegt die Aufgabe zugrunde, Leiterplatten zum Erstellen einer formschlüssigen Verbindung von mindestens zwei Leiterplatten anzugeben, die einer erhöhten mechanischen Belastung standhält.

Diese Aufgabe wird durch eine Leiterplatte mit mindestens einem Verbindungshaken dadurch gelöst, dass der Verbindungshaken über einen Steg an einer Seite der ersten Leiterplatte angebracht und derart geformt ist, dass er durch eine passende Verbindungsausnehmung in der zweiten Leiterplatte durchsteckbar ist und dass zwischen dem Verbindungshaken und der ersten Leiterplatte ein Freiraum von in etwa der Dicke der zweiten Leiterplatte vorgesehen ist, wodurch beide Leiterplatten nach dem Durchstecken des Verbindungshakens durch die Verbindungsausnehmung gegeneinander verdrehbar sind.

Die Aufgabe wird schließlich durch eine Leiterplatte mit mindestens einer Verbindungsausnehmung der eingangs genannten Art dadurch gelöst, dass die Verbindungsausnehmung derart auf der ersten Leiterplatte angeordnet ist, dass die zweite Leiterplatte beim Durchstecken des Verbindungshakens durch die Verbindungsausnehmung einen Winkel relativ zu ihrer Endposition nach Herstellen der mechanischen Verbindung aufweist, wodurch beide Leiterplatten nach dem Durchstecken gegeneinander verdrehbar sind.

Durch das erfindungsgemäße Durchstecken und Verdrehen von Leiterplatten bzw. Flachbaugruppen gegeneinander entsteht eine mechanische Kopplung, die Schwing- und/oder Schockbewegungen sehr gut aufnimmt, was z.B. beim Einsatz in der Robotik von Vorteil ist. Bei der Verwendung von Verbindungshaken mit einer Einstecknase entsteht vorteilhaft eine zusätzliche Verzapfung, wodurch eine einfache Entriegelung nicht mehr möglich ist.

In einer vorteilhaften Form der Ausführung sind die Bereiche um die Verbindungselemente zueinander passend mit Kontaktelementen versehen, mittels derer nach der mechanischen Kopplung der Leiterplatten bzw. Flachbaugruppen eine elektrische Verbindung mittels Lötung, Kontaktfeder, Stecker oder Stift und Buchse, Leitkleber etc. herstellbar ist. Die stabile mechanische Kopplung führt dabei zu einer Entlastung der möglichen elektrischen Kontaktierverbindungen, wodurch eine sichere Vormontage der Baugruppe ermöglicht wird.

In einer weiteren vorteilhaften Ausführungsform ist bei einer Leiterplatte mit einer Verbindungsausnehmung auf der Seite, auf der die zweite Leiterplatte angebracht wird, eine Nut zur Führung der zweiten Leiterplatte vorgesehen. Diese zusätzliche Führung bewirkt einen weiteren Stabilitätsgewinn für die mechanische Kopplung der Leiterplatten.

Die Figuren zeigen:
- FIG 1: zwei Leiterplatten zur mechanischen Kopplung mit- tels Durchstecken und Verschieben derselben gegen- einander vor dem Durchstecken,
- FIG 2: die zwei Leiterplatten aus Fig 1 nach dem Durchste- cken,
- FIG 3: die zwei Leiterplatten aus Fig 1 nach dem Verschie- ben,
- FIG 4: zwei Leiterplatten zur mechanischen Kopplung mit- tels Durchstecken, Verschieben derselben gegenein- ander und Verriegeln vor dem Durchstecken,
- FIG 5: die zwei Leiterplatten aus Fig 4 nach dem Durchste- cken,
- FIG 6: die zwei Leiterplatten aus Fig 4 nach dem Verschie- ben,
- FIG 7: die zwei Leiterplatten aus Fig 4 nach dem Verrie- geln,
- FIG 8: zwei Leiterplatten mit einer zusätzlichen Führungs- nut zur mechanischen Kopplung mittels Durchstecken und Verschieben nach dem Verschieben,
- FIG 9: die zwei Leiterplatten aus Fig 8 in einer um 180 Grad gedrehten Ansicht,
- FIG 10: zwei Leiterplatten zur mechanischen Kopplung mit- tels Durchstecken und Verdrehen vor dem Durchste- cken,
- FIG 11: die zwei Leiterplatten aus Fig 10 nach dem Durch- stecken,
- FIG 12: die zwei Leiterplatten aus Fig 10 nach dem Verdre- hen.

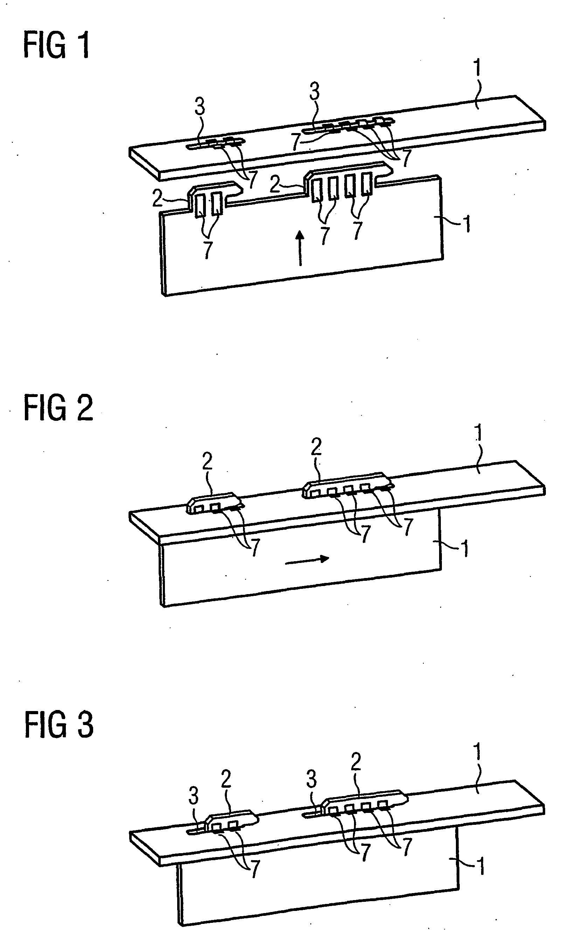

Fig 1 zeigt zwei Leiterplatten 1 zur mechanischen Kopplung mittels Durchstecken und Verschieben, von denen eine zwei verschieden große Verbindungshaken 2 aufweist und die andere zwei dazu passend geformte Verbindungsausnehmungen 3. Die beiden Leiterplatten 1, die in der Figur noch räumlich getrennt sind, werden senkrecht zueinander befestigt. Der Freiraum zwischen den Verbindungshaken 2 und dem Rand der unteren Leiterplatte 1 entspricht der Dicke der oberen Leiterplatte 1. Sowohl auf der unteren Leiterplatte im Bereich der Verbindungshaken 2 als auch auf der oberen Leiterplatte im Bereich der Verbindungsausnehmungen 3 sind Kontaktelemente 7 für die Herstellung einer elektrischen Verbindung aufgebracht.

Fig 2 zeigt die beiden Leiterplatten 1 aus Fig 1, wobei die Verbindungshaken 2 der unteren Leiterplatte 1 durch die Verbindungsausnehmungen 3 der oberen Leiterplatte 1 durchgesteckt worden sind.

Fig 3 zeigt die beiden Leiterplatten 1 aus Fig 1, die nach dem Durchstecken gegeneinander verschoben worden und somit stabil miteinander mechanisch gekoppelt sind. Die in den Bereichen um die Verbindungshaken 2 und die Verbindungsausnehmungen 3 aufgebrachten Kontaktelemente 7 passen in diesem Status genau überein und können z.B. durch Verlöten elektrisch verbunden werden. Hier und in den folgenden Figuren ist das Bezugszeichen 7 aus Gründen der Übersichtlichkeit nicht mehr aufgeführt; die Position der Kontaktelemente 7 entspricht der in den Figuren 1 bis 3 angegebenen.

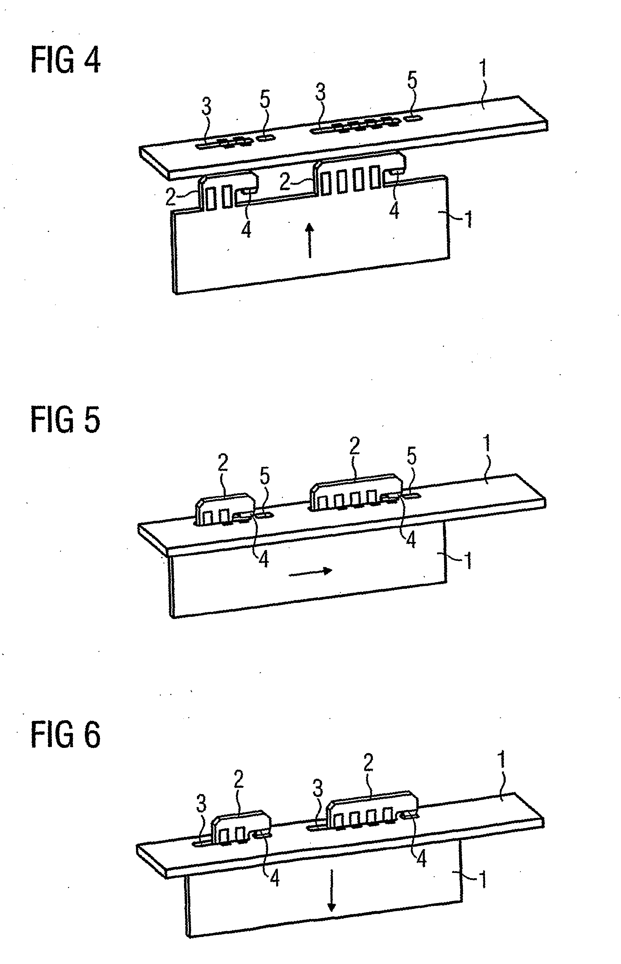

Fig 4 zeigt zwei Leiterplatten 1 zur mechanischen Kopplung mittels Durchstecken, Verschieben derselben gegeneinander und anschließendem Verriegeln. Die beiden Leiterplatten, die in der Figur noch räumlich getrennt sind, werden senkrecht zueinander befestigt. Zum Verriegeln sind an den äußeren Enden der Verbindungshaken 2 der unteren Leiterplatte 1 Einstecknasen 4 angebracht, die in dafür vorgesehene Einstecklöcher 5 in der oberen Leiterplatte 1 eingerastet werden können. Der Freiraum zwischen den Einstecknasen 4 und dem Rand der unteren Leiterplatte 1 entspricht der Dicke der oberen Leiterplatte 1. Die Einstecklöcher 5 befinden sich in Verlängerung der Verbindungsausnehmung 3. Sowohl auf der unteren Leiterplatte im Bereich der Verbindungshaken 2 als auch auf der oberen Leiterplatte im Bereich der Verbindungsausnehmungen 3 sind Kontaktelemente 7 für die Herstellung einer elektrischen Verbindung aufgebracht.

Fig 5 zeigt die beiden Leiterplatten 1 aus Fig 4, wobei die Verbindungshaken 2 der unteren Leiterplatte 1 durch die Verbindungsausnehmungen 3 der oberen Leiterplatte 1 durchgesteckt worden sind.

Fig 6 zeigt die beiden Leiterplatten 1 aus Fig 4, die nach dem Durchstecken gegeneinander verschoben worden sind. Die in den Bereichen um die Verbindungshaken 2 und die Verbindungsausnehmungen 3 aufgebrachten Kontaktelemente 7 passen in diesem Status genau überein. Da bei dieser Ausführung der Freiraum zwischen Verbindungshaken 2 und Rand der unteren Leiterplatte 1 aufgrund der zusätzlichen Einstecknase 4 etwas vergrößert ist, hat die mechanische Kopplung in diesem Zustand der Leiterplatten 1 noch nicht ihre volle Stabilität erreicht.

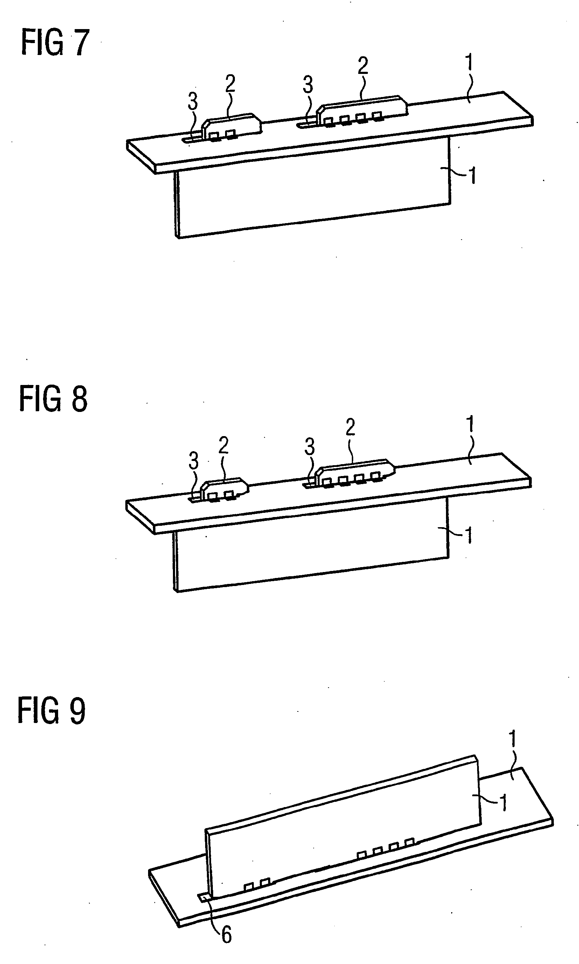

Fig 7 zeigt wiederum die beiden Leiterplatten 1 aus Fig 4, die nach dem Verschieben durch Einstecken der Einstecknasen 4 in die Einstecklöcher 5 in Gegenrichtung des Durchsteckens der Verbindungshaken 2 durch die Verbindungsausnehmungen 3 verriegelt worden sind. In dieser stabilen Endposition kann nun auch die elektrische Kontaktierung der passend aufgebrachten Kontaktelemente 7 erfolgen.

Fig 8 zeigt zwei Leiterplatten 1 mit einer zusätzlichen Führungsnut 6 zur mechanischen Kopplung mittels Durchstecken und Verschieben, wobei die Form der Verbindungshaken 2 und der Verbindungsausnehmungen 3 der der Leiterplatten aus Fig 1 entspricht. Die Führungsnut 6 befindet sich auf der Unterseite der oberen Leiterplatte 1 und ist in dieser Darstellung nicht zu sehen. Beim Durchstecken der Verbindungshaken 2 der unteren Leiterplatte 1 durch die Verbindungsausnehmungen 3 der oberen Leiterplatte 1 wird gleichzeitig die untere Leiterplatte 1 in die zur zusätzlichen Führung in die Unterseite der oberen Leiterplatte 1 eingefrästen Nut 6 eingesteckt. Diese zusätzliche Fixierung verleiht der mechanischen Kopplung eine erhöhte Stabilität.

Fig 9 zeigt die beiden Leiterplatten 1 aus Fig 8 in einer um 180 Grad gedrehten Ansicht. In dieser ist nun auch die Führungsnut 6, in der die Leiterplatte 1 mit Verbindungshaken 2 beim Verschieben geführt wurde, gut zu sehen.

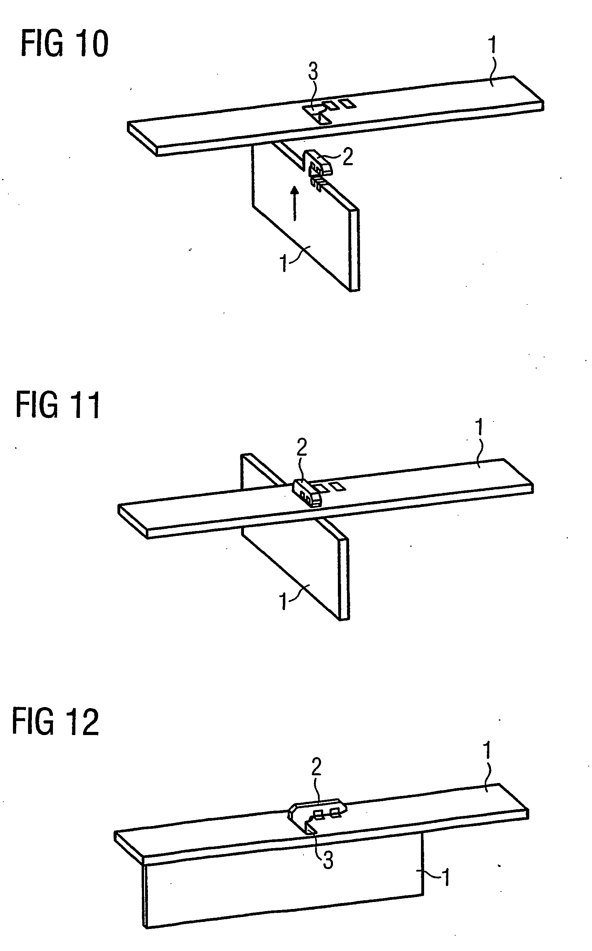

Fig 10 zeigt zwei Leiterplatten 1 zur mechanischen Kopplung mittels Durchstecken und Verdrehen. Deutlich zu erkennen ist der Verbindungshaken 2 in dieser Ausführung nur über einen Steg mit dem Rand der unteren Leiterplatte 1 verbunden, da die Leiterplatte 1 mit dem Verbindungshaken 2 in der Verbindungsausnehmung 3 der oberen Leiterplatte 1 drehbar sein muss. Aus demselben Grunde kann in dieser Ausführung die mechanische Kopplung auch nur über einen Verbindungshaken 2 und dazu passender Verbindungsausnehmung 3 erfolgen. Die Kontaktelemente 7 sind in dieser Ausführung auf der unteren Leiterplatte 1 zweigeteilt sowohl auf dem Verbindungshaken 2 als auch auf dem oberen Rand der Leiterplatte 1 aufgebracht. Auf der oberen Leiterplatte 1 befinden sich die Kontaktelemente 7 neben der Verbindungsausnehmung 3 an der Position, in der sich der Verbindungshaken 2 der unteren Leiterplatte 1 nach Verdrehen der Leiterplatten 1 befinden wird.

Fig 11 zeigt die beiden Leiterplatten 1 aus Fig 10, wobei der Verbindungshaken 2 der unteren Leiterplatte 1 durch die Verbindungsausnehmung 3 der oberen Leiterplatte 1 durchgesteckt worden ist.

Fig 12 zeigt die beiden Leiterplatten 1 aus Fig 10 nach Herstellen der mechanischen Kopplung durch Verdrehen der beiden Leiterplatten 1 gegeneinander. In dieser Endposition liegen die Kontaktelemente 7 wieder passend übereinander und können beispielsweise durch Verlöten miteinander elektrisch verbunden werden.

Zusammenfassend betrifft die Erfindung Leiterplatten mit mindestens einem Verbindungshaken oder mindestens einer Verbindungsausnehmung zur Herstellung einer mechanischen Verbindung von mindestens zwei Leiterplatten bzw. Flachbaugruppen. Diese mechanische Verbindung hält, in Erfüllung der Aufgabe der Erfindung, einer erhöhten mechanischen Belastung wie z.B. Schwing- und/oder Schockbeanspruchungen stand und ist somit insbesondere für einen Einsatz in der Robotik optimal geeignet. Erreicht wird dies durch die speziell geformten Verbindungshaken im Zusammenspiel mit den dazu passenden Verbindungsausnehmungen, durch die die Leiterplatten nach dem Durchstecken der Haken durch die Ausnehmungen mittels. Verschieben der Leiterplatten gegeneinander zu einer stabilen formschlüssigen Verbindung zusammengefügt werden.

## Patentansprüche

1. Leiterplatte (1) mit einem Verbindungshaken (2) zur Herstellung einer mechanischen Verbindung mit einer zweiten Leiterplatte (1),
**dadurch gekennzeichnet, dass**
der Verbindungshaken (2) über einen Steg an einer Seite der ersten Leiterplatte (1) angebracht und derart geformt ist, dass er durch eine passende Verbindungsausnehmung (3) in der zweiten Leiterplatte (1) durchsteckbar ist und dass zwischen dem Verbindungshaken (2) und der ersten Leiterplatte (1) ein Freiraum von in etwa der Dicke der zweiten Leiterplatte (1) vorgesehen ist, wodurch beide Leiterplatten (1) nach dem Durchstecken des Verbindungshakens (2) durch die Verbindungsausnehmung (3) gegeneinander verdrehbar sind.

2. Leiterplatte nach Anspruch 1,
wobei an dem mindestens einen Verbindungshaken (2) jeweils mindestens ein Kontaktelement (7) aufgebracht ist, mittels dem nach der mechanischen Verbindung der beiden Leiterplatten (1) eine elektrische Verbindung zu jeweils geeignet angebrachten Kontaktelementen (7) auf der zweiten Leiterplatte (1) herstellbar ist.

3. Leiterplatte (1) mit einer Verbindungsausnehmung (3) zur Herstellung einer mechanischen Verbindung mit einer zweiten Leiterplatte (1), wobei die Verbindungsausnehmung (3) derart geformt ist, dass ein an der zweiten Leiterplatte (1) angebrachter Verbindungshaken (2) passend durch die Verbindungsausnehmung (3) durchsteckbar ist,
**dadurch gekennzeichnet, dass**
die Verbindungsausnehmung (3) derart auf der ersten Leiterplatte (1) angeordnet ist, dass die zweite Leiterplatte (1) beim Durchstecken des Verbindungshakens (2) durch die Verbindungsausnehmung (3) einen Winkel relativ zu ihrer Endposition nach Herstellen der mechanischen Verbindung aufweist, wodurch beide Leiterplatten (1) nach dem Durchstecken gegeneinander verdrehbar sind.

4. Leiterplatte nach Anspruch 3,
wobei im Bereich der Endposition des Verbindungshakens (2) der zweiten Leiterplatte (1) mindestens ein Kontaktelement (7) aufgebracht ist, mittels dem nach der mechanischen Verbindung der beiden Leiterplatten (1) eine elektrische Verbindung zu jeweils geeignet angebrachten Kontaktelementen (7) auf der zweiten Leiterplatte (1) herstellbar ist.

## Claims

1. Circuit board (1) with a connecting hook (2) for establishing a mechanical connection to a second circuit board (1),
**characterised in that**
the connecting hook (2) is attached via a web to one side of the first circuit board (1) and is shaped so that it is able to be pushed through a suitable connection cutout (3) in the second circuit board (1) and that a free space of around the thickness of the second circuit board (1) is provided between the connecting hook (2) and the first circuit board (1), with the two printed circuit boards (1) being able to be turned in relation to each other after the connecting hook (2) has been pushed through the connection cutout (3).

2. Circuit board according to claim 1,
with at least a contact element (7) being attached to the at least one connecting hook (2) in each case, by means of which, after the mechanical connection of the two printed circuit boards (1) an electrical connection is able to be established to respective suitable contact elements (7) attached to the second circuit board (1).

3. The circuit board (1) with a connection cutout (3) for establishing a mechanical connection to a second circuit board (1), with the connection cutout (3) being shaped such that a connecting hook (2) attached to the second circuit board (1) can be pushed through the connection cutout (3) in an appropriate manner,
**characterised in that**
the connection cutout (3) is arranged on the first circuit board (1) such that the second circuit board (1), when the connecting hook (2) is pushed through the connection cutout (3), makes an angle relative to its end position after the mechanical connection is established, with the two printed circuit boards (1) being able to be turned in a relation to each other after insertion though the cutout.

4. Circuit board according to claim 3,
with at least one contact element (7) being fitted in the area of the end position of the connecting hook (2) of the second circuit board (1), by means which, after mechanical connection of the two printed circuit boards (1) an electrical connection is able to be established to a suitably attached contact element (7) on the second circuit board (1).

## Revendications

1. Plaquette ( 1 ) à circuits imprimés ayant un crochet ( 2 ) de liaison pour ménager une liaison mécanique avec une deuxième plaquette ( 1 ) à circuits imprimés,
**caractérisée en ce que** le crochet ( 2 ) de liaison est mis par un bord sur un côté de la première plaquette ( 1 ) à circuits imprimés et est formé de façon à pouvoir être enfilé dans un évidement ( 3 ) adapté de liaison de la deuxième plaquette ( 1 ) à circuits imprimés et **en ce qu'**il est prévu entre le crochet ( 2 ) de liaison ET la première plaquette ( 1 ) à circuits imprimés, un espace libre d'environ l'épaisseur de la deuxième plaquette ( 1 ) à circuits imprimés, de sorte que les deux plaquettes ( 1 ) à circuits imprimés peuvent être tournées l'une par rapport à l'autre après que le crochet ( 2 ) de liaison a été enfilé dans l'évidement ( 3 ) de liaison.

2. Plaquette à circuits imprimés suivant la revendication 1,
dans laquelle il est appliqué sur au moins un crochet 2 ) de liaison, respectivement au moins un élément ( 7 ) de contact, au moyen duquel il est ménagé, après la liaison mécanique des deux plaquettes ( 1 ) à circuits imprimés, une liaison électrique vers des éléments ( 7 ) de contact mis respectivement de manière appropriée sur la deuxième plaquette ( 1 ) à circuits imprimés.

3. Plaquette ( 1 ) à circuits imprimés ayant un évidement ( 3 ) de liaison pour ménager une liaison mécanique avec une deuxième plaquette ( 1 ) à circuits imprimés, l'évidement ( 3 ) de liaison étant formé de manière à ce qu'un crochet ( 2 ) de liaison mis sur la deuxième plaquette ( 1 ) à circuits imprimés puisse être enfilé de manière adaptée dans l'évidement ( 3 ) de liaison,
**caractérisée en ce que** l'évidement ( 3 ) de liaison est disposé sur la première plaquette ( 1 ) à circuits imprimés, de manière à ce que la deuxième plaquette ( 1 ) à circuits imprimés fasse, lorsque que le crochet ( 2 ) de liaison est enfilé dans l'évidement ( 3 ) de liaison, un angle par rapport à sa position finale après que la liaison mécanique a été ménagée, de sorte que les deux plaquettes ( 1 ) à circuits imprimés peuvent tourner l'une par rapport à l'autre après l'enfilement.

4. Plaquette à circuits imprimés suivant la revendication 3,
dans laquelle il est appliqué dans la zone de la position d'extrémité du crochet ( 2 ) de liaison de la deuxième plaquette ( 1 ) à circuits imprimés, au moins un élément ( 7 ) de contact, au moyen duquel on peut ménager, après la liaison mécanique des deux plaquettes ( 1 ) à circuits imprimés, une liaison électrique vers des éléments ( 7 ) de contact mis respectivement de manière appropriée sur la deuxième plaquette ( 1 ) à circuits imprimés.
